# EUROPEAN PATENT SPECIFICATION

(11) **EP 3 696 869 B1**
(45) Date of publication and mention of the grant of the patent: **06.05.2026**
(21) Application number: 18866112.8
(22) Date of filing: 21.06.2018
(51) Int. Cl.: H10N 30/00, B82Y 30/00, H10N 30/072, H10N 30/093

(54) **NANO-SCALE SINGLE CRYSTAL THIN FILM**
NANOSKALIGE EINKRISTALL-DÜNNSCHICHT
FILM MINCE MONOCRISTALLIN À ÉCHELLE NANOMÉTRIQUE

(30) Priority: 13.10.2017 CN 201710950965
(43) Date of publication of application: 19.08.2020
(73) Proprietor: Jinan Jingzheng Electronics Co., Ltd., Shandong 250101 (CN)
(72) Inventor: HU, Hui, Jinan Shandong 250101 (CN); ZHU, Houbin, Jinan Shandong 250101 (CN); HU, Wen, Jinan Shandong 250101 (CN); LUO, Juting, Jinan Shandong 250101 (CN); ZHANG, Xiuquan, Jinan Shandong 250101 (CN); LI, Zhenyu, Jinan Shandong 250101 (CN); LI, Yangyang, Jinan Shandong 250101 (CN)
(74) Representative: Kolster Oy Ab
(86) International application number: PCT/CN2018/092185
(87) International publication number: WO 2019/071978

(56) References cited:
- EP-A1- 1 936 679
- EP-A2- 0 647 022
- EP-A2- 0 651 449
- WO-A1-2016/194976
- CN-A- 1 632 911
- CN-A- 105 420 674
- JP-A- 2017 188 550

## Description

### FIELD OF TECHNOLOGY

The disclosure relates to a nano-scale single crystal thin film and in particular to a nano-scale single crystal thin film comprising a thin film layer with a thickness in the range of 10 nm to 2,000 nm.

### BACKGROUND

Oxide single crystal thin films, such as lithium tantalate single crystal thin films and lithium niobate single crystal thin films, due to their large electromechanical coupling coefficients, are widely used as piezoelectric materials in surface acoustic wave (SAW) elements, and they are widely used in optical signal processing, information storage, electronic devices, and similar areas. These oxide single crystal thin films can be used as basic materials to prepare optoelectronic devices and integrated optical circuits with the features of high frequency, high bandwidth, high integration, high capacity, and low power.

As the demand for reducing the power consumption of devices, reducing the volumes of devices, and increasing the integration level of devices has become higher and higher, the thickness of wafers has become thinner and thinner.

### SUMMARY

The invention provides a nano-scale single crystal thin film that can improve the bonding force between a single crystal thin film and a substrate as defined by claim 1.

According to an embodiment of the invention, the material for forming the nano-scale single crystal thin film layer may be lithium niobate, lithium tantalate, or quartz, and the thickness of the nano-scale single crystal thin film layer may be in the range of 10 nm to 2,000 nm.

According to an embodiment of the invention, the material for forming the substrate layer may be lithium niobate, lithium tantalate, silicon, quartz, sapphire, or silicon carbide, and the thickness of the substrate layer may be in the range of 0.1 mm to 1 mm.

According to an embodiment of the invention, the isolation layer may be a silicon dioxide layer. The thickness of the isolation layer may be in the range of 0.05 µm to 4 µm, the thickness of the first transition layer may be in the range of 2 nm to 10 nm, and the thickness of the second transition layer may be in the range of 0.5 nm to 15 nm.

According to an embodiment of the invention, the first transition layer may have a thickness that is different from the thickness of the second transition layer.

According to an embodiment of the invention, the material for forming the nano-scale single crystal thin film layer may be the same as the material of the substrate layer.

According to an embodiment of the invention, the material for forming the nano-scale single crystal thin film layer may be different from the material of the substrate layer.

According to an embodiment of the invention, in the first transition layer, in the direction from the nano-scale single crystal thin film layer to the isolation layer, the content of the element from the nano-scale single crystal thin film layer may gradually decrease, and a content of the element from the isolation layer may gradually increase. In the second transition layer, in the direction from the isolation layer to the substrate layer, a content of the element from the isolation layer may gradually decrease, and the content of the element from the substrate layer may gradually increase.

According to an embodiment of the invention, the element H in the first transition layer may have a maximum concentration at a certain position, and the concentration of the element H in the first transition layer may gradually decrease from the position with maximum concentration toward the isolation layer and the nano-scale single crystal thin film layer.

According to the invention, the first transition layer and the second transition layer of the nano-scale single crystal thin film can release stress, reduce defects in the single crystal thin film and the isolation layer, and improve the quality of the single crystal thin film and the isolation layer, thereby reducing transmission losses. In addition, the stress release can make the media at interfaces have more uniformity and reduce the scattering of light during a propagation process, thereby reducing the transmission losses.

According to the invention, the element H in the first transition layer is beneficial for improving the bonding force of the single crystal thin film, and in the preparation of a filter device using the nano-scale single crystal thin film, the phenomenon of large-area debonding can be avoided when a cutting process is performed. Therefore, the utilization rate of the nano-scale single crystal thin film can be improved, and the yield of the filter device can be further improved.

### BRIEF DESCRIPTION OF THE DRAWINGS

The above description and other objects and features of the disclosure will become clearer through the following description of exemplary embodiments in conjunction with the accompanying drawings, among which:
Figure 1 is a schematic diagram illustrating a nano-scale single crystal thin film according to the invention.
Figure 2 is a transmission electron microscope (TEM) image illustrating a nano-scale lithium tantalate single crystal film (LTOISI) with a silicon substrate, corresponding to the nano-scale single crystal film of Figure 1.
Figures 3 and 4 are enlarged TEM images of regions A and B in Figure 2, respectively.
Figure 5 is a secondary ion mass spectrum (SIMS) of an LTOISI.
Figure 6 and Figure 7 are the element distribution diagrams of the bonding surface and the deposition surface of an LTOISI, respectively.
Figure 8 is a transmission electron microscope (TEM) image illustrating a nano-scale lithium niobate single crystal thin film (LNOI) with a lithium niobate substrate, corresponding to the nano-scale single crystal thin film of Figure 1.
Figure 9 and Figure 10 are enlarged TEM images of region C and region D in Figure 8, respectively.
Figure 11 is a secondary ion mass spectrum (SIMS) of an LNOI.
Figure 12 and Figure 13 are the element distribution diagrams of the bonding surface and the deposition surface of an LNOI, respectively.
Figure 14 is a schematic diagram illustrating a bonding force test performed on an LTOISI sample according to the invention.

### DESCRIPTION OF THE EMBODIMENTS

Reference will now be made in detail to the embodiments and methods of the disclosure, which constitute the optimum modes of practicing the disclosure that are presently known to the inventors. It should be understood, however, that the disclosed embodiments are merely examples of the disclosure that can be implemented in various alternative forms. Accordingly, the specific details disclosed herein should not be construed as limiting, but merely as a representative basis for any aspect of the disclosure and/or as a representative basis for teaching a person skilled in the art to implement the invention as defined by the claims.

A traditional grinding and thinning process can reduce the thickness of a single crystal thin film to a range from several micrometers to tens of micrometers. However, not only does this method require the sacrifice of most of the thickness of a wafer, thereby increasing production costs, but a micron-scale single crystal thin film also no longer meets the demands of current equipment with regard to the thicknesses of single crystal thin films. The present inventors have found that nano-scale thin films made of lithium niobate and lithium tantalate have obvious advantages in terms of the miniaturization, high frequency processing, speediness and energy saving of related devices. The smart cut method can be used to obtain a nano-scale single crystal thin film. The smart cut method not only can meet the demands of a device with regard to the thickness of single crystal films, but it can also obtain nanometer-thick single crystal thin films without sacrificing a surplus wafer, which can significantly increase the utilization rate of a wafer and reduce production costs.

In the smart cut process, a separation is generally carried out after an oxide single crystal thin film is bonded to a supporting substrate. The magnitude of the bonding force between the single crystal thin film and the substrate will directly affect the yield of a manufactured device during the cutting process in the subsequent production process. To this end, exemplary embodiments of the disclosure provide a nano-scale single crystal thin film in which the bonding force of the single crystal thin film to the substrate can be improved. The nano-scale single crystal thin film may be comprised of a thin film layer, an isolation layer, and a substrate layer. A first transition layer is located between the thin film layer and the isolation layer, and a second transition layer is located between the isolation layer and the substrate layer.

Hereinafter, the nano-scale single crystal thin film according to the exemplary embodiments of the disclosure is described in detail with reference to the accompanying drawings.

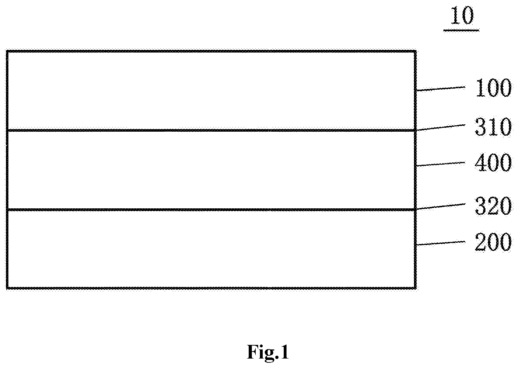

Figure 1 is a schematic view illustrating a nano-scale single crystal thin film according to the invention.

Referring to Figure 1, a nano-scale single crystal thin film 10 according to to the invention sequentially comprises a thin film layer 100, a first transition layer 310, an isolation layer 400, a second transition layer 320, and a substrate layer 200. The first transition layer 310 is located between the thin film layer 100 and the isolation layer 400, and the second transition layer 320 is located between the isolation layer 400 and the substrate layer 200.

According to an exemplary embodiment of the disclosure, the nano-scale single crystal thin film 10 may be prepared as a wafer that may have a diameter in the range of 2 inches to 12 inches (1 inch = 2.54 cm).

According to the invention, the thin film layer 100 is a nano-scale single crystal thin film layer, and it may be a piezoelectric thin film layer. The material for forming the thin film layer 100 may be lithium niobate, lithium tantalate, or quartz. The surface of the thin film layer 100 is a polished surface. The thickness of the thin film layer 100 is in the range of 10 nm to 2,000 nm. Preferably, the thickness of the thin film layer 100 is in the range of 10 nm to 200 nm, 300 nm to 900 nm, or 900 nm to 1,500 nm.

According to an exemplary embodiment of the invention, the material for forming the substrate layer 200 may be lithium niobate, lithium tantalate, silicon, quartz, sapphire, or silicon carbide. The thickness of the substrate layer 200 may be in the range of 0.1 mm to 1 mm. Preferably, the thickness of the substrate layer 200 may be in the range of 0.1 mm to 0.2 mm, 0.3 mm to 0.5 mm, or 0.2 mm to 0.5 mm. According to an exemplary embodiment of the disclosure, the material for forming the substrate layer 200 may be the same as the material of the thin film layer 100. However, the disclosure is not limited thereto, and the material for forming the substrate layer 200 may be different from the thin film layer 100.

According to an exemplary embodiment of the invention, the isolation layer 400 may be a silicon dioxide layer that is prepared by a deposition method or an oxidation method on the substrate layer 200. The thickness of the isolation layer 400 may be in the range of 0.05 µm to 4 µm. Preferably, the thickness of the isolation layer 400 may be in the range of 0.05 µm to 0.5 µm, 0.5 µm to 1 µm, 1 µm to 2 µm, or 2 µm to 3 µm.

According to the invention, the first transition layer 310 is amorphous and the second transition layer 320 may be amorphous, and the thicknesses of the first transition layer 310 and the second transition layer 320 may be different. The thickness of the first transition layer 310 is in the range of 2 nm to 10 nm, and the thickness of the second transition layer 320 is in the range of 0.5 nm to 15 nm.

According to the invention, the first transition layer 310 contains a certain concentration of the element H having a concentration in the range of 1×10¹⁹ atoms/cm³ to 1x10²² atoms/cm³. The element H is derived from water molecules adsorbed on the surface after a plasma treatment, and can form hydrogen bonds to promote the bonding and to enhance the bonding force of the nano-scale single crystal thin film. Therefore, the bonding force of the nano-scale single crystal thin film can be enhanced by increasing the concentration of the element H in the first transition layer 310.

The concentration of the element H in the first transition layer 310 may be increased using various methods. For example, the concentration of the element H in the first transition layer 310 may be increased by extending the time for a plasma treatment. Specifically, the surface of a wafer (for example, a target thin film wafer and/or a substrate wafer) may be subjected to a plasma treatment for 30 s to 180 s so that greater numbers of active functional groups (for example, -OH) are generated on the surface of the treated wafer. The active functional groups can allow water molecules in the air to be absorbed into the surface of the wafer during bonding, thereby introducing the element H to the bonding surface. Preferably, the plasma treatment can be performed on the surface of the wafer for 60 s to 120 s.

According to another exemplary embodiment of the disclosure, when the surface of the wafer is treated with plasma, a high-purity gas with slightly higher moisture content may be selected for the plasma treatment, thereby increasing the content of the element H in the first transition layer 310. Preferably, the moisture content (volume fraction) of the high-purity gas used for the plasma treatment is greater than 2×10⁻⁶.

According to another exemplary embodiment of the disclosure, the surface of the wafer treated by plasma may be subjected to megasonic cleaning using deionized water to increase the content of the element H in the first transition layer 310.

According to an exemplary embodiment of the invention, in the first transition layer 310, the element H has a maximal concentration at a certain position, and the concentration of the element H gradually decreases from the position with maximal concentration toward the thin film layer 100 and the isolation layer 400. In addition, according to an exemplary embodiment of the disclosure, the first transition layer 310 and the second transition layer 320 may contain further elements used in the plasma treatment, such as the element Ar, element N, and similar elements. The elements such as Ar and N in the second transition layer 320 are diffused from the first transition layer 310.

According to an exemplary embodiment of the invention, the first transition layer 310 contains inherent elements of the thin film layer 100 and the isolation layer 400. In the first transition layer 310, the concentrations of the elements from the thin film layer 100 gradually decrease from the thin film layer 100 toward the isolation layer 400, and the concentrations of the elements from the isolation layer 400 gradually decrease from the isolation layer 400 toward the thin film layer 100. According to an exemplary embodiment of the disclosure, the second transition layer 320 contains inherent elements of the substrate layer 200 and the isolation layer 400. In the second transition layer 320, the concentrations of the elements from the substrate layer 200 gradually decrease from the substrate layer 200 toward the isolation layer 400, and the concentrations of the elements from the isolation layer 400 gradually decrease from the isolation layer 400 toward the substrate layer 200.

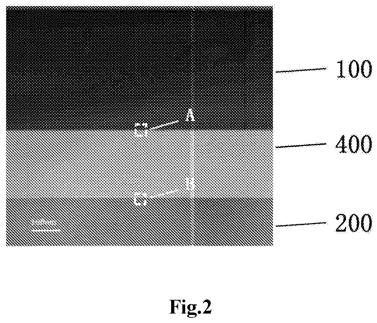

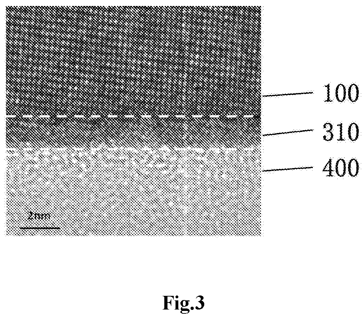

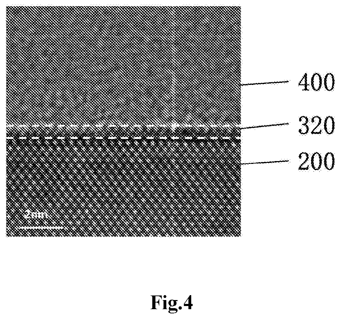

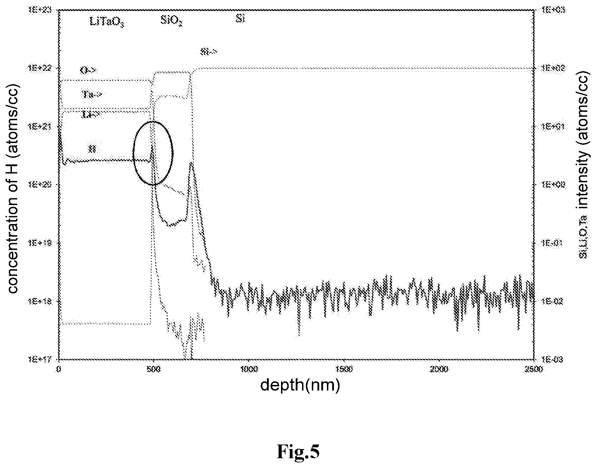

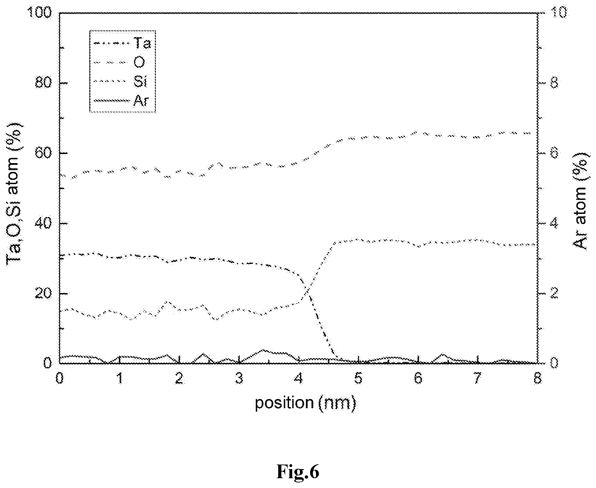

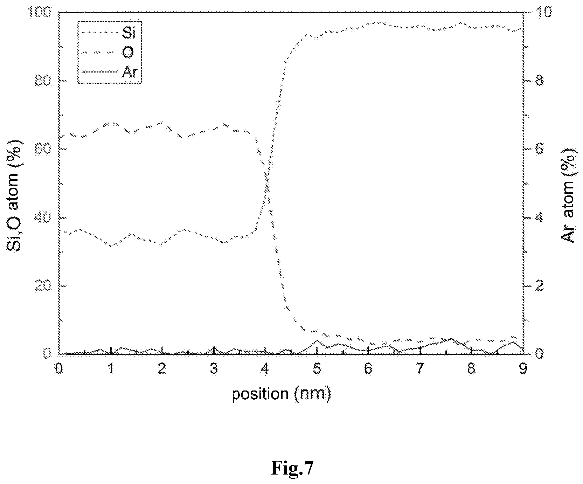

Figure 2 is a transmission electron microscope (TEM) image illustrating a nano-scale lithium tantalate single-crystal film (LTOISI) with a silicon substrate, corresponding to the nano-scale single-crystal film of Figure 1. Figure 3 and Figure 4 are enlarged TEM images of region A and region B in Figure 2, respectively. Figure 5 is a secondary ion mass spectrum (SIMS) image of an LTOISI. Figure 6 and Figure 7 are element distribution diagrams of the bonding surface and the deposition surface of an LTOISI, respectively.

In the nano-scale lithium tantalate single crystal thin film (LTOISI) with the silicon substrate in Figures 2 to 7, the thin film layer 100 is a lithium tantalate (LiTaO₃) layer, the isolation layer 400 is a silicon dioxide (SiO₂) layer, and the substrate layer 200 is a silicon (Si) layer. As can be seen from Figure 3, the region A that is located at the interface between the thin film layer 100 and the isolation layer 400 in Figure 2 includes three layers with clear interfaces, i.e., the thin film layer 100, the first transition layer 310, and the isolation layer 400. It can be seen from Figure 4 that the region B located at the interface between the isolation layer 400 and the substrate layer 200 in Figure 2 includes three layers with clear interfaces, i.e., the isolation layer 400, the second transition layer 320, and the substrate layer 200. Among these layers, the thin film layer 100 has a thickness of 300 nm, the isolation layer SiO₂ has a thickness of 200 nm, and the Si substrate has a thickness of 0.5 mm.

Referring to Figure 5, the region in the circle in Figure 5 represents the first transition layer 310 of the LTOISI. It can be seen from Figure 5 that the first transition layer 310 contains a high concentration of the element H, the element H has a maximum concentration in the first transition layer 310, and the concentration of the element H decreases from the position with maximum concentration toward the thin film layer 100 and the isolation layer 400. The high concentration of the element H in the first transition layer 310 of the LTOISI improves the bonding force of the LTOISI.

In addition, as can be seen from Figure 5, a certain concentration of the element H also exists in the second transition layer 320 located between the isolation layer 400 and the substrate layer 200, which results from the diffusion of the element H due to an annealing process.

Referring to Figure 6, the first transition layer 310 of the LTOISI has a thickness of approximately 2 nm. In the first transition layer 310, the concentration of the element Ta from the thin film layer 100 gradually decreases in the direction from the thin film layer 100 to the isolation layer 400. Additionally, the concentration of the element Si from the isolation layer gradually decreases in the direction from the isolation layer 400 to the thin film layer 100. In addition, the bonding surface (the first transition layer 310) of the LTOISI contains the element Ar.

It can be seen from Figure 7 that the thickness of the second transition layer 320 of the LTOISI is approximately 1 nm. In the second transition layer 320, the concentration of the element O for the isolation layer 400 gradually decreases in the direction from the isolation layer 400 to the substrate layer 200, and the concentration of the element Si for the substrate layer 200 gradually decreases in the direction from the substrate layer 200 to the isolation layer 400. In addition, in the second transition layer 320 of the LTOISI, the element Ar that is diffused from the first transition layer 310 may also exist.

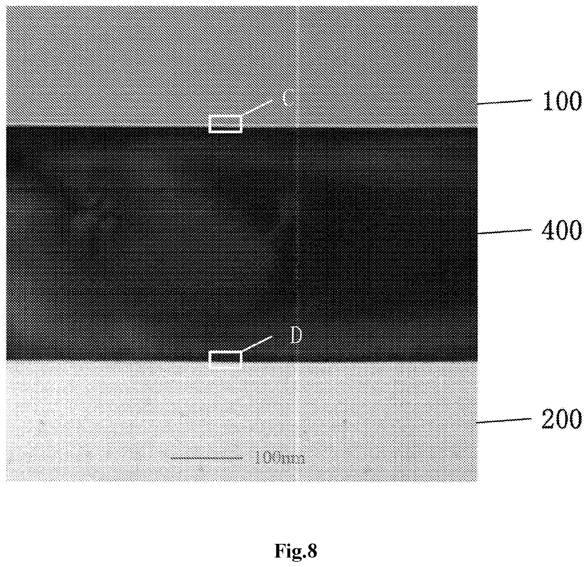

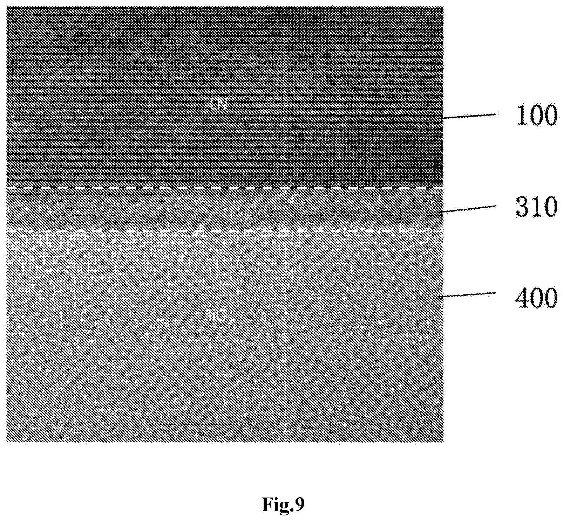

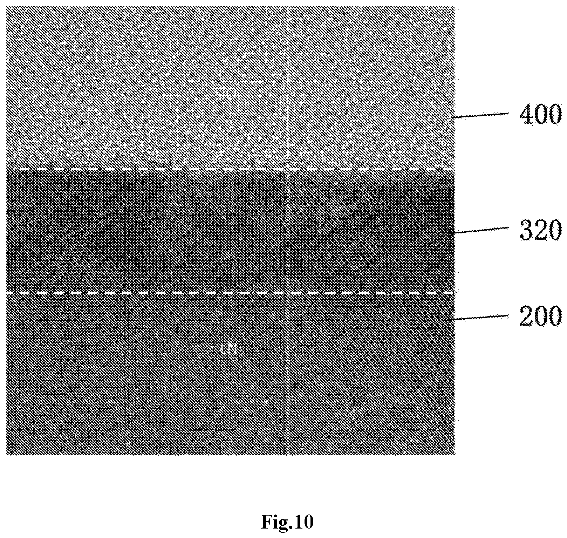

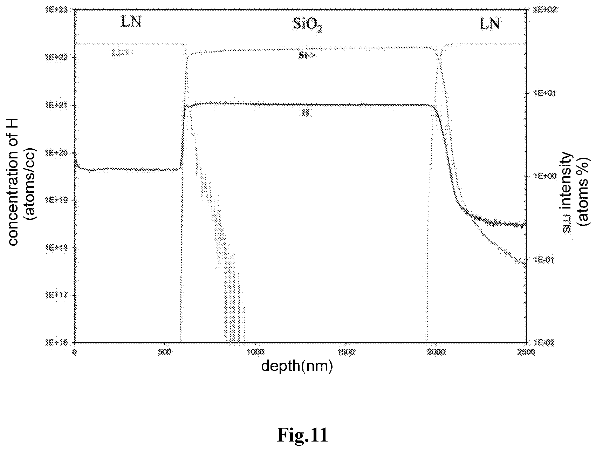

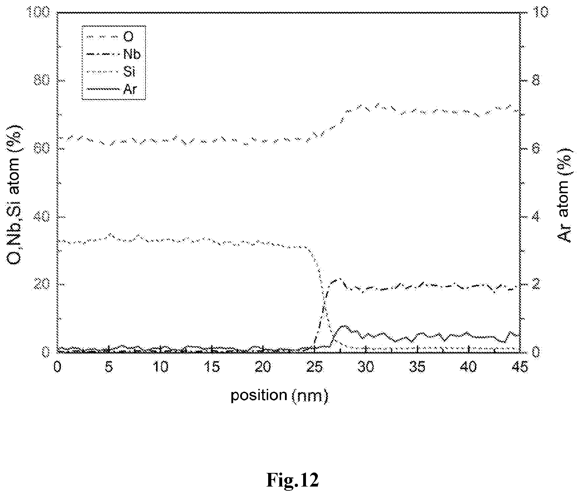

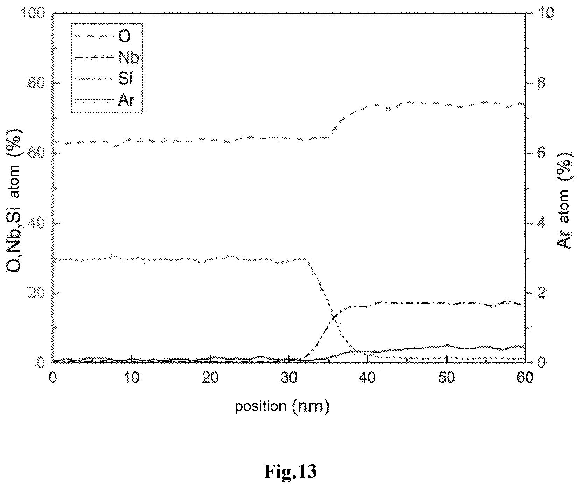

Figure 8 is a transmission electron microscope (TEM) image illustrating a nano-scale lithium niobate single crystal film (LNOI) with a lithium niobate substrate, corresponding to the nano-scale single crystal thin film of Figure 1. Figure 9 and Figure 10 are enlarged TEM images of region C and region D in Figure 8, respectively. Figure 11 is a secondary ion mass spectrum (SIMS) image of an LNOI. Figure 12 and Figure 13 are element distribution diagrams of the bonding surface and the deposition surface of an LNOI, respectively.

In the lithium niobate single crystal thin film (LNOI) of Figures 8 to 13, the thin film layer 100 is a lithium niobate (LiNbO₃) layer (that is, the LN thin film in Figures 9 and 10), the isolation layer 400 is a silicon dioxide (SiO₂) layer, and the substrate layer 200 is a lithium niobate layer. As can be seen from Figures 8 to 10, the transition layer 300 of the LNOI includes a first transition layer 310 and a second transition layer 320. The thickness of the first transition layer 310 is smaller than that of the second transition layer 320, and there are clear interfaces between any two adjacent layers among the thin film layer 100, the first transition layer 310, the isolation layer 400, the second transition layer 30, and the substrate layer 200. Thus, the scattering loss of light propagation in the film is greatly reduced, and performance of the nano-scale single crystal thin film is improved. In this embodiment, the thickness of the thin film layer 100 of the LNOI is 500 nm, the thickness of the isolation layer 400 is 2,000 nm, and the thickness of the substrate layer 200 is 0.35 mm.

It can be seen from Figure 11 that the first transition layer 310 of the LNOI contains a high concentration of element H. Additionally, the concentration of the element H has a maximum in a certain range of depth (referred to as a position with maximum concentration), and the concentration of the element H gradually decreases from the position with maximum concentration toward the thin film layer 100 and the isolation layer 400.

Referring to Figure 12, the thickness of the first transition layer 310 of the LNOI is approximately 3 nm. In the first transition layer 310 of the LNOI, the concentration of the element Nb for the thin film layer 100 gradually decreases in the direction from the thin film layer 100 to the isolation layer 400. Additionally, the concentration of the element Si for the isolation layer gradually decreases in the direction from the isolation layer 400 to the thin film layer 100. In addition, the bonding surface (first transition layer 310) of the LNOI also contains the element Ar.

Referring to Figure 13, the thickness of the second transition layer 320 of the LNOI is approximately 10 nm. In the second transition layer 320, the concentration of the element Si from the isolation layer 400 gradually decreases in the direction from the isolation layer 400 to the substrate layer 200, and the concentration of the element Nb from the substrate layer 200 gradually decreases in the direction from the substrate layer 200 to the isolation layer 400. In addition, the Ar element diffused from the first transition layer 310 may also exist in the second transition layer 320 of the LNOI.

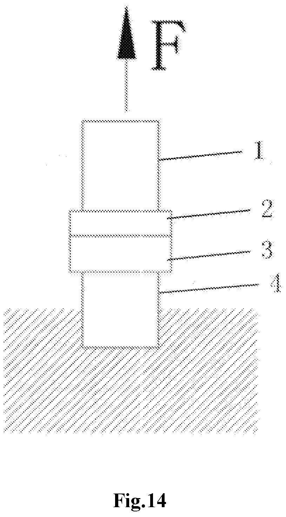

To further verify the relationship between the concentration of the element H in the first transition layer and the bonding force of the single crystal thin film, a bonding force test is performed on the nano-scale single crystal thin film according to the exemplary embodiment. Figure 14 is a schematic diagram illustrating the bonding force test performed on an LTOISI sample according to the invention.

The Czochralski method is used to test the bonding force of nano-scale single crystal thin films. In order to exclude the influence of other variables, all samples of the nano-scale single crystal thin film used in the bonding force test are LTOISI samples, and other characteristics of the tested LTOISI samples, such as the thickness, are substantially the same, except for the different concentrations of the elements H in the first transition layers.

Referring to Figure 14, each LTOISI sample is cut into 2 cm × 2 cm squares, and the cut samples are placed between fixture 1 and fixture 4. For ease of description, only the thin film layer 2 and the substrate layer 3 of the LTOISI sample are shown here. The upper surface of the thin film layer 2 of the LTOISI sample is adhered to the lower surface of fixture 1 with an adhesive, and the lower surface of the substrate layer 3 of the LTOISI sample is adhered to the upper surface of fixture 4 with an adhesive. Both fixture 1 and fixture 4 have a diameter of 1.5 cm. After the adhesive is completely cured, as shown in Figure 14, a tensile force F is applied to the LTOISI sample in the vertical direction in order to test the magnitude of the tensile force, which is required when the nano-scale single crystal thin film layer of the LTOISI sample is detached from the substrate layer. The larger the tensile force is, the greater the bonding force of the nano-scale single crystal thin film sample is. The data for the bonding force test on the LTOISI samples with different concentrations of element H is listed in Table 1.

**Table 1. Data for the bonding force test (cc = cm³)**

| Sample No. | Concentration of H (atoms/cc) | Tensile force (F) (N) |
|---|---|---|
| 1 | 9.27×10²⁰ | 7021.48 |
| 2 | 4.61×10²⁰ | 5052.38 |
| 3 | 1.55×10²⁰ | 3124.12 |

As shown in Table 1, the larger the concentration of the element H in the first transition layer is, the larger the tensile force is that is required when the thin film layer 2 of the LTOISI sample is detached from the substrate layer 3. Therefore, the bonding force of the nano-scale single crystal thin film can be enhanced by increasing the concentration of the element H in the first transition layer of the nano-scale single crystal thin film.

A method for preparing the nano-scale single crystal thin film comprises at least the following steps: (1) performing ion implantation on the bonding surface of an oxide single crystal wafer (a target thin film wafer) so that an ion-implanting layer is formed in the oxide single crystal wafer, (2) activating the bonding surfaces of the oxide single crystal wafer and a substrate wafer with plasma, (3) performing the bonding of the cleaned oxide single crystal wafer and the cleaned substrate wafer at room temperature to obtain a bonded body, and (4) heat-treating the bonded body to remove the oxide single crystal thin film from the ion-implanting layer.

Hereinafter, the method for preparing the nano-scale single crystal thin film according to an exemplary embodiment of the disclosure is described in detail.

First, a target thin film wafer and a substrate wafer are prepared. The target thin film wafer may be a lithium niobate wafer, a lithium tantalate wafer, a quartz wafer, or a similar wafer. The substrate wafer may be a lithium niobate wafer, a lithium tantalate wafer, a silicon wafer, a quartz wafer, a sapphire wafer, a silicon carbide wafer, or a similar wafer. The target thin film wafer and the substrate wafer may be the same or different. The thickness of the target thin film wafer may be in the range of 100 µm to 500 µm, and the thickness of the substrate wafer may be in the range of 50 µm to 2,000 µm.

Next, ions (for example, H ions or He ions) are implanted into the target thin film wafer through an ion implantation process, so that the target thin film wafer that is formed includes a thin film layer, a separation layer, and a surplus material layer (the thickness of the final thin film layer depends on the energy of the implanted ions). The separation layer is located between the film layer and the surplus material layer. The thickness of the thin film layer of the nano-scale single crystal thin film to be formed is controlled via ion implantation to be in the range of 10 nm to 2,000 nm, and the accuracy of the thickness is controlled within ±5 nm. Because the removal amount with the subsequent chemical-mechanical polishing process is small, the deterioration of the non-uniformity of the thin film caused by the chemical-mechanical polishing is sufficiently reduced, which causes the uniformity of the thin film to be less than 30 nm.

Next, an isolation layer (for example, a SiO₂ layer) is formed on one surface of the substrate wafer through a deposition method or an oxidation method, and the isolation layer is annealed. According to an exemplary embodiment of the disclosure, an isolation layer comprising, for example, SiO₂, may be formed through a process such as a thermal oxidation process or a deposition process, and then the isolation layer may be annealed to remove internal impurities and stress. Alternatively, the isolation layer may be subjected to chemical-mechanical polishing to obtain a smooth surface suitable for a direct bonding process. Furthermore, the isolation layer is polished to a target thickness in order to obtain a substrate wafer whose surface is covered by an isolation layer with a certain thickness.

Next, the target thin film wafer and the substrate wafer are cleaned, and a cleaned surface of the target thin film wafer that is formed with a thin film layer (that is, the surface of the target thin film wafer on which an ion-implantation is performed) and a cleaned surface of the isolation layer on the substrate layer are subjected to plasma treatment using, for example, Ar gas. The surfaces treated by plasma are brought into contact at room temperature in order to bond directly and to form a bonded body. The method of surface treatment by plasma may include radio frequency plasma treatment, jet plasma treatment, atmospheric pressure plasma treatment, and similar treatments. The bonding process may include, for example, direct bonding in an air environment, vacuum bonding, pressured bonding, and similar types of bonding.

According to an exemplary embodiment of the disclosure, the plasma treatment activates the bonding surface and a high bonding force can be obtained at a lower temperature. Additionally, many active functional groups are generated on the plasma-treated surface, and the active functional groups can render water molecules in the air to be absorbed into the surface so that the element H is introduced into the bonding surface (i.e., a transition layer). The element H in the transition layer can form hydrogen bonds, thereby promoting bonding and enhancing the bonding force of the bonded body. The content of the element H in a first transition layer can be increased by extending the time for the plasma treatment by using a gas with higher moisture content and performing megasonic cleaning on the plasma-treated wafer surface with deionized water in order to increase the bonding force of the bonded body.

Next, the bonded body is heated to separate the thin film layer and the surplus material layer. According to an exemplary embodiment of the disclosure, the bonded body is heated at a temperature in the range of 100°C to 400°C so that the ions in the implanted layer undergo a chemical reaction to become gas molecules or atoms, and tiny bubbles occur. When the heating time increases or the heating temperature increases, the number of bubbles increases, and the volumes of the bubbles gradually increases. When these bubbles join, the thermal separation of the thin film layer from the surplus material layer is achieved, thereby obtaining an initial nano-scale single crystal thin film that includes the thin film layer, the isolation layer, and the substrate layer.

Next, an annealing process is performed on the obtained initial nano-scale single crystal thin film at a temperature in the range of 300°C to 600°C in order to eliminate the lattice defects introduced by ion implantation in the thin film layer. Additionally, the thin film layer of the annealed initial nano-scale single crystal thin film is subjected to chemical-mechanical polishing to a predetermined thickness. Finally, the nano-scale single crystal film is obtained.

The disclosure provides a nano-scale single crystal film with reduced internal defects. The first transition layer and the second transition layer of the nano-scale single crystal film can release stress, reduce defects in the single crystal film and the isolation layer, and improve the quality of the single crystal thin film and the isolation layer, thereby playing the role of reducing transmission losses. In addition, the stress release can make the media at interfaces have more uniformity and reduce the scattering of light during the propagation process, thereby reducing the transmission losses.

The disclosure provides a nano-scale single crystal thin film with an increased bonding force for the single-crystal thin film. The nano-scale single crystal thin film comprises a thin film layer with a thickness of 10 nm to 2,000 nm and a first transition layer located between the thin film layer and an isolation layer that contains a certain concentration of the element H. Since the nano-scale single crystal thin film has an increased bonding force, when electronic devices such as filters are prepared using the nano-scale single crystal thin film, the phenomenon of large-area debonding during a cutting process can be avoided, thereby improving the utilization rate of the nano-scale single crystal thin film and the yields of electronic devices.

## Claims

1. A nano-scale single crystal thin film (10), comprising:
a nano-scale single crystal thin film layer (100),
an isolation layer (400),
a substrate layer (200), and
a first transition layer (310) and a second transition layer (320), wherein the first transition layer (310) is located between the nano-scale single crystal thin film layer (100) and the isolation layer and the second transition layer (320) is located between the isolation layer (400) and the substrate layer (200), wherein the first transition layer (310) is amorphous, wherein the first transition layer (310) contains a certain concentration of element hydrogen, H, **characterised in that** the concentration of the element H in the first transition layer (310) is in the range of 1x10¹⁹ atoms/cm³ to 1x10²² atoms/cm³, wherein the element H is derived from water molecules adsorbed on a surface of a target thin film wafer and/or a substrate wafer after a plasma treatment of the surface.

2. The nano-scale single crystal thin film (10) according to claim 1, wherein the material that forms the nano-scale single crystal thin film layer (100) is lithium niobate, lithium tantalate, or quartz, and the nano-scale single crystal thin film layer (100) has a thickness in the range of 10 nm to 2,000 nm.

3. The nano-scale single crystal thin film (10) according to claim 1, wherein the material that forms the substrate layer (200) is lithium niobate, lithium tantalate, silicon, quartz, sapphire, or silicon carbide, and the substrate layer (200) has a thickness in a range from 0.1 mm to 1 mm.

4. The nano-scale single crystal thin film (10) according to claim 1, wherein the isolation layer (400) is a silicon dioxide layer, and the isolation layer (400) has a thickness in the range of 0.05 µm to 4 µm, the first transition layer I (310) has a thickness in the range of 2 nm to 10 nm, and the second transition layer (320) has a thickness in the range of 0.5 nm to 15 nm.

5. The nano-scale single crystal thin film (10) according to claim 1, wherein the first transitior layer (310) has a thickness that is different from the thickness of the second transition layer (320).

6. The nano-scale single crystal thin film (10) according to claims 1, 2, 3, or 4, wherein the material that forms the nano-scale single crystal thin film layer (100) is the same as the material of the substrate layer (200).

7. The nano-scale single crystal thin film (10) according to claims 1, 2, 3, or 4, wherein the material that forms the nano-scale single crystal thin film layer (100) is different from the material of the substrate layer (200).

8. The nano-scale single crystal thin film (10) according to claim 1, wherein, in the first transitior layer (310), in a direction from the nano-scale single crystal thin film layer (100) toward the isolation layer (400), the content of an element from the nano-scale single crystal thin film layer (100) gradually decreases and the content of an element from the isolation layer (400) gradually increases; and in the second transitior layer (320), in the direction from the isolation layer (400) toward the substrate layer (200), the content of an element from the isolation layer (400) gradually decreases and the content of an element from the substrate layer (200) gradually increases.

9. The nano-scale single crystal thin film (10) according to claim 1, wherein the element H in the first transition layer (310) has a maximum concentration at a certain position and the concentration of the element H in the first transition layer (310) gradually decreases from the position with maximum concentration toward the isolation layer (400) and the nano-scale single crystal thin film layer (100).

## Patentansprüche

1. Nanoskaliger Einkristall-Dünnfilm (10), umfassend:
eine nanoskalige Einkristall-Dünnfilmschicht (100),
eine Isolierschicht (400),
eine Substratschicht (200), und
eine erste Übergangsschicht (310) und eine zweite Übergangsschicht (320), wobei sich die erste Übergangsschicht (310) zwischen der nanoskaligen Einkristall-Dünnfilmschicht (100)
und der Isolierschicht befindet und sich die zweite Übergangsschicht (320) zwischen der Isolierschicht (400) und der Substratschicht (200) befindet, wobei die erste Übergangsschicht (310) amorph ist,
wobei die erste Übergangsschicht (310) eine bestimmte Konzentration eines Wasserstoffelements, H, enthält, **dadurch gekennzeichnet, dass** die Konzentration des Elements H in der ersten Übergangsschicht (310) im Bereich von 1 x10¹⁹ Atome/cm³ bis 1x10²² Atome/cm³ liegt,
wobei das Element H aus Wassermolekülen abgeleitet wird, die auf einer Oberfläche eines Ziel-Dünnschichtwafers und/oder eines Substratwafers nach Plasmabehandlung der Oberfläche adsorbiert werden.

2. Nanoskaliger Einkristall-Dünnfilm (10)
nach Anspruch 1, wobei das Material, das die nanoskalige Einkristall-Dünnfilmschicht (100) bildet Lithium-Niobat, Lithium-Tantalat oder Quarz ist und die nanoskalige Einkristall-Dünnfilmschicht (100) eine Dicke im Bereich von 10 nm bis 2.000 nm aufweist.

3. Nanoskaliger Einkristall-Dünnfilm (10)
nach Anspruch 1, wobei das Material, das die Substratschicht (200) bildet, Lithiumniobat, Lithiumtantalat, Silizium, Quarz, Saphir oder Siliziumkarbid ist, und die Substratschicht (200) eine Dicke in einem Bereich von 0,1 mm bis 1 mm aufweist.

4. Nanoskaliger Einkristall-Dünnfilm (10) nach Anspruch 1, wobei die Isolierschicht (400) eine Siliziumdioxidschicht ist, und die Isolierschicht (400) eine Dicke im Bereich von 0,05 µm bis 4 µm aufweist, die erste Übergangsschicht I (310) eine Dicke im Bereich von 2 nm bis 10 nm aufweist und die zweite Übergangsschicht (320) eine Dicke im Bereich von 0,5 nm bis 15 nm aufweist.

5. Nanoskaliger Einkristall-Dünnfilm (10)
nach Anspruch 1, wobei die erste Übergangs schicht (310) eine Dicke aufweist, die sich von der Dicke der zweiten Übergangsschicht (320) unterscheidet.

6. Nanoskaliger Einkristall-Dünnfilm (10)
nach Anspruch 1, 2, 3 oder 4, wobei das Material, das die nanoskalige Einkristall-Dünnfilmschicht (100) bildet, dasselbe ist wie das Material der Substratschicht (200) unterscheidet.

7. Nanoskaliger Einkristall-Dünnfilm (10)
nach Anspruch 1, 2, 3 oder 4, wobei das Material, das die nanoskalige Einkristall-Dünnfilmschicht (100) bildet, sich von dem Material der Substratschicht (200) unterscheidet.

8. Nanoskaliger Einkristall-Dünnfilm (10)
nach Anspruch 1, wobei in der ersten Übergangs schicht (310), in einer Richtung von der nanoskaligen Einkristall-Dünnfilmschicht (100) in Richtung der Isolierschicht (400), der Gehalt eines Elements aus der nanoskaligen Einkristall-Dünnfilmschicht (100) allmählich abnimmt und der Gehalt eines Elements aus der Isolierschicht (400) allmählich zunimmt; und in der zweiten Übergangs schicht (320), in der Richtung von der Isolierschicht (400) zu der Substratschicht (200), der Gehalt eines Elements aus der Isolierschicht (400) allmählich abnimmt und der Gehalt eines Elements aus der Substratschicht (200) allmählich zunimmt.

9. Nanoskaliger Einkristall-Dünnfilm (10)
nach Anspruch 1, wobei das Element H in der ersten Übergangsschicht (310) eine maximale Konzentration an einer bestimmten Position aufweist und die Konzentration des Elements H in der ersten Übergangsschicht (310) allmählich von der Position mit maximaler Konzentration in Richtung Isolierschicht (400) und der nanoskaligen Einkristall-Dünnfilmschicht (100) abnimmt.

## Revendications

1. Film (10) mince monocristallin à échelle nanométrique, comprenant :
une couche (100) de film mince monocristallin à échelle nanométrique,
une couche d'isolation (400),
une couche de substrat (200), et
une première couche de transition (310) et une deuxième couche de transition (320),
dans lequel la première couche de transition (310) est située entre la couche (100) de film mince monocristallin à échelle nanométrique,
et la couche d'isolation et la deuxième couche de transition (320) est située entre la couche d'isolation (400) et la couche de substrat (200), dans lequel la première couche de transition (310) est amorphe,
dans lequel la première couche de transition (310)
contient une certaine concentration de l'élément hydrogène, H, **caractérisé en ce que** la concentration de l'élément H dans la première couche de transition (310) est dans une plage de 1 × 10¹⁹ atomes/cm³ à 1 × 10²² atomes/cm³,
dans lequel l'élément H est issu de molécules d'eau adsorbées sur une surface d'une tranche cible de film mince et/ou d'une tranche de substrat après un traitement au plasma de la surface.

2. Film (10) mince monocristallin à échelle nanométrique,
selon la revendication 1, dans lequel le matériau qui forme la couche (100) de film mince monocristallin à échelle nanométrique,
est du niobate de lithium, du tantalate de lithium, ou du quartz, et la couche (100) de film mince monocristallin à échelle nanométrique,
présente une épaisseur dans une gamme de 10 nm à 2 000 nm.

3. Film (10) mince monocristallin à échelle nanométrique,
selon la revendication 1, dans lequel le matériau qui forme la couche de substrat (200)
est du niobate de lithium, du tantalate de lithium, du silicium, du quartz, du saphir, ou du carbure de silicium, et la couche de substrat (200) présente une épaisseur dans une plage de 0,1 mm à 1 mm.

4. Film (10) mince monocristallin à échelle nanométrique,
selon la revendication 1, dans lequel la couche d'isolation (400) est une couche de dioxyde de silicium, et la couche d'isolation (400)
présente une épaisseur dans une gamme de 0,05 µm à 4 µm, la première couche de transition (310), présente une épaisseur dans une gamme de 2 nm à 10 nm, et la deuxième couche de transition (320) présente une épaisseur dans une gamme de 0,5 nm à 15 nm.

5. Film (10) mince monocristallin à échelle nanométrique,
selon la revendication 1, dans lequel la première couche de transition (310) présente une épaisseur qui est différente de l'épaisseur de la deuxième couche de transition (320).

6. Film (10) mince monocristallin à échelle nanométrique,
selon la revendication 1, la revendication 2, la revendication 3, ou la revendication 4, dans lequel le matériau qui forme la couche (100) de film mince monocristallin à échelle nanométrique,
est le même que le matériau de la
couche de substrat (200).

7. Film (10) mince monocristallin à échelle nanométrique,
selon la revendication 1, la revendication 2, la revendication 3, ou la revendication 4, dans lequel le matériau qui forme la couche (100) de film mince monocristallin à échelle nanométrique
est différent du matériau de la couche de substrat (200).

8. Film (10) mince monocristallin à échelle nanométrique,
selon la revendication 1, dans lequel, dans la première couche de transition (310), dans une
direction depuis la couche (100) de film mince monocristallin à échelle nanométrique vers la couche d'isolation (400), le
contenu d'un élément provenant de la couche (100) de film mince monocristallin à échelle nanométrique
diminue progressivement et le contenu d'un élément provenant de la couche d'isolation (400)
augmente progressivement ; et dans la deuxième
couche de transition (320), dans la direction depuis la couche d'isolation (400) vers la couche de substrat (200), le contenu d'un élément provenant de la couche d'isolation (400) diminue progressivement et le contenu d'un élément provenant de la couche de substrat (200) augmente progressivement.

9. Film (10) mince monocristallin à échelle nanométrique,
selon la revendication 1, dans lequel l'élément H dans la première couche de transition (310)
présente une concentration maximale à une certaine position et la concentration de l'élément H dans la première couche de transition (310),
diminue progressivement depuis la position avec une concentration maximale vers la couche d'isolation (400) et la couche (100) de film mince monocristallin à échelle nanométrique.
